# EUROPÄISCHE PATENTSCHRIFT

(11) **EP 3 208 845 B1**
(45) Veröffentlichungstag und Bekanntmachung des Hinweises auf die Patenterteilung: **04.12.2019**
(21) Anmeldenummer: 16156491.9
(22) Anmeldetag: 19.02.2016
(51) Int. Cl.: H01L 23/495, H01L 21/48

(54) **VERFAHREN ZUR HERSTELLUNG EINES SCHALTUNGSTRÄGERS, SCHALTUNGSTRÄGER, VERFAHREN ZUR HERSTELLUNG EINES HALBLEITERMODULS UND HALBLEITERMODUL**
METHOD FOR MANUFACTURING A CIRCUIT CARRIER, CIRCUIT CARRIER, METHOD OF MANUFACTURING A SEMICONDUCTOR MODULE AND SEMICONDUCTOR MODULE
PROCEDE DE FABRICATION D'UN PORTE-CIRCUIT, PORTE-CIRCUIT, PROCEDE DE FABRICATION D'UN MODULE SEMI-CONDUCTEUR ET MODULE SEMI-CONDUCTEUR

(43) Veröffentlichungstag der Anmeldung: 23.08.2017
(73) Patentinhaber: Heraeus Deutschland GmbH & Co. KG, 63450 Hanau (DE)
(72) Erfinder: Eisele, Ronald, 24229 Surendorf (DE)
(74) Vertreter: Kilchert, Jochen

(56) Entgegenhaltungen:
- WO-A1-2010/081752
- WO-A1-2015/040737
- WO-A1-2015/115665
- DE-A1-102013 226 334
- JP-A- 2011 003 800
- JP-A- 2011 071 301
- US-A1- 2011 290 863
- US-A1- 2012 152 510

## Beschreibung

Die Erfindung betrifft ein Verfahren zur Herstellung eines Schaltungsträgers, insbesondere eines Stanzgitters oder einer Leiterbahn, für einen Halbleiterbaustein. Des Weiteren betrifft die Erfindung einen Schaltungsträger, insbesondere ein Stanzgitter oder eine Leiterbahn, für einen Halbleiterbaustein. Außerdem betrifft die Erfindung ein Verfahren zur Herstellung eines Halbleitermoduls, umfassend einen Schaltungsträger und mindestens einen Halbleiterbaustein, der mit dem Schaltungsträger verbunden ist. Ferner betrifft die Erfindung ein Halbleitermodul, umfassend einen Schaltungsträger und mindestens einen Halbleiterbaustein, der mit dem Schaltungsträger verbunden ist.

Leistungselektronische Leistungshalbleiter bestehen meist aus dehnungsarmen Werkstoffen und müssen zur elektrischen Kontaktierung und um eine ausreichende Entwärmung erzielen zu können, auf einem Schaltungsträger montiert werden, der sowohl ausreichend elektrischen Strom leitet, als auch gute Wärmeleiteigenschaften besitzt. Im einfachsten Fall handelt es sich bei dem Schaltungsträger um eine Leiterbahn, insbesondere um eine Kupferleiterbahn, die als Träger einzelner oder mehrerer Leistungshalbleiter dient. Leistungshalbleiter weisen typischerweise Silizium (Si) oder Siliziumcarbid (SiC) auf. Silizium besitzt eine thermische Dehnung von 2,6 ppm/K, wohingegen Siliziumcarbid eine thermische Dehnung von 3,7 ppm/K aufweist. Diese Ausdehnungskoeffizienten sind deutlich geringer als die Ausdehnungskoeffizienten typischer Werkstoffe von Schaltungsträgern. Üblicherweise bestehen Schaltungsträger, die in Form eines Stanzgitters oder einer Leiterbahn vorliegen, aus Kupfer (Cu). Kupfer weist einen Ausdehnungskoeffizient von 17,8 ppm/K auf.

Aus der Druckschrift WO2015/115665 (US2017/0170137) ist eine Verbindungsstruktur bekannt, welche zur Verminderung von thermischem Stress bei niedrigen Umgebungstemperaturen verbunden werden kann.

Aus der Druckschrift DE102013226334 ist ein Schaltungsträger mit einem sinterverbundenen Halbleiterbaustein bekannt, wobei ein thermischer Ausdehnungskoeffizient wenigstens einer der Sinterschichten oder aller Sinterschichten bevorzugt zwischen dem Ausdehnungskoeffizienten eines Fügepartners und dem Ausdehnungskoeffizienten der zur Sinterschicht benachbarten Sinterschicht liegt.

Um eine sichere elektrische und thermische Kontaktierung zu erzielen, werden die Leistungshalbleiter mit Hilfe von Zinn (Sn) oder Blei (Pb) als Basislot auf den Schaltungsträger gelötet. Auch das Aufsintern von Halbleiterbausteinen auf einen Schaltungsträger ist bekannt. In allen Fällen weisen der Leistungshalbleiter und der Schaltungsträger jedoch eine deutliche thermisch-mechanische Fehlanpassung auf, die zu großen Spannungen unmittelbar nach der Abkühlung von der Verbindungstemperatur auf die Raumtemperatur führt. In Abhängigkeit von der Größe und Dicke des Halbleiters kann die Fehlanpassung derart groß werden, dass die mechanische Spannung zur Zerstörung der Verbindung zwischen dem Halbleiter und dem Schaltungsträger führt.

Zur Reduzierung der thermischen Dehnung von Kupfer-Leiterbahnen bzw. Kupfer-Stanzgittern werden bereits Legierungen des Kupfers mit dehnungsarmen Metallen eingesetzt. Es existieren beispielsweise Kupfer-Wolfram-Legierungen (CuW) und Kupfer-Molybdän-Legierungen (CuMo). Daraus resultieren thermische Dehnungen zwischen 8 ppm/K und 12 ppm/K.

CuW- und CuMo-Legierungen sind technologisch aufwendig herzustellen und äußerst teuer. Insbesondere die Legierungsbildung erfordert aufgrund des hohen Schmelzpunktunterschiedes zwischen Kupfer und den Legierungsbestandteilen Wolfram (W) und Molybdän (Mo) äußerst umfangreiche Verfahrensschritte bis zur erfolgreichen Legierung. Außerdem wird die Wärmeleitfähigkeit des reinen Kupfers durch die Legierungsbildung stark reduziert. Dies stellt einen wesentlichen Nachteil der kostenintensiven Legierung dar.

Ausgehend von diesem Stand der Technik ist es Aufgabe der vorliegenden Erfindung, ein Verfahren zur Herstellung eines Schaltungsträgers, insbesondere eines Stanzgitters oder einer Leiterbahn, für einen Halbleiterbaustein anzugeben, das äußerst einfach und kostengünstig durchzuführen ist und mit dessen Hilfe ein optimierter Schaltungsträger herstellbar ist.

Des Weiteren ist es Aufgabe der vorliegenden Erfindung, einen Schaltungsträger anzugeben, der äußerst dehnungsarm und gleichzeitig kostengünstig ist.

Des Weiteren ist es eine Aufgabe der vorliegenden Erfindung, ein Verfahren zur Herstellung eines Halbleitermoduls anzugeben. Ferner ist es Aufgabe der vorliegenden Erfindung, ein weiterentwickeltes Halbleitermodul anzugeben, wobei das Halbleitermodul äußerst dehnungsarm ausgebildet ist.

Erfindungsgemäß wird diese Aufgabe mit Blick auf das Verfahren zur Herstellung eines Schaltungsträgers, insbesondere eines Stanzgitters oder einer Leiterbahn, für einen Halbleiterbaustein durch den Gegenstand des Anspruches 1, mit Blick auf den Schaltungsträger, insbesondere das Stanzgitter oder die Leiterbahn, für einen Halbleiterbaustein durch den Gegenstand des Anspruches 6, mit Blick auf das Verfahren zur Herstellung eines Halbleitermoduls, umfassend einen Schaltungsträger und mindestens einen Halbleiterbaustein, der mit dem Schaltungsträger verbunden ist, durch den Gegenstand des Anspruches 12 und mit Blick auf das Halbleitermodul, umfassend einen Schaltungsträger und mindestens einen Halbleiterbaustein, der mit dem Schaltungsträger verbunden ist, durch den Gegenstand des Anspruches 15 gelöst.

Die Erfindung beruht auf dem Gedanken, ein Verfahren zur Herstellung eines Schaltungsträgers, insbesondere eines Stanzgitters oder einer Leiterbahn, für einen Halbleiterbaustein, anzugeben, wobei mindestens eine erste Kupferschicht oder eine erste Kupferlegierungsschicht mit einem ersten Ausdehnungskoeffizient und mindestens eine zweite Schicht aus einem zweiten, dehnungsarmen Material mit einem zweiten Ausdehnungskoeffizient, der kleiner als der erste Ausdehnungskoeffizient ist, bei einer Verbindungstemperatur von 150 °C bis 300 °C miteinander verbunden werden. Besonders bevorzugt erfolgt das Verbinden der ersten Kupferschicht oder der ersten Kupferlegierungsschicht mit der zweiten Schicht aus einem zweiten Material durch ein Niedertemperatursinterverfahren. Der herzustellende Schaltungsträger für mindestens einen Halbleiterbaustein kann als Stanzgitter oder als eine Leiterbahn ausgebildet sein.

Zwischen der Kupferschicht oder Kupferlegierungsschicht und der zweiten Schicht kann mindestens eine Verbindungsschicht aus einem Verbindungsmaterial ausgebildet sein. Das Verbindungsmaterial kann eine Verbindung herstellen, die Temperaturen oberhalb der Verbindungstemperatur standhält und vorzugsweise ein Diffusionsmetall, insbesondere Silber (Ag) und/oder eine Silberlegierung und/oder Gold (Au) und/oder eine Goldlegierung und/oder Kupfer (Cu) und/oder eine Kupferlegierung, aufweist.

Die Verbindungstemperatur kann 200 °C - 280 °C, insbesondere 220 °C - 270 °C, insbesondere 240 °C - 260 °C, insbesondere 250 °C, betragen. Vorzugsweise entspricht die Verbindungstemperatur im Wesentlichen der Montagetemperatur bei der Verbindung des hergestellten Schaltungsträgers mit mindestens einem Halbleiterbaustein.

Das zweite, dehnungsarme Material mit dem zweiten Ausdehnungskoeffizient der mindestens zweiten Schicht weist vorzugsweise eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), auf. Als besonders bevorzugtes Material hinsichtlich des zweiten Materials der mindestens zweiten Schicht hat sich Molybdän (Mo) bzw. eine Molybdänlegierung erwiesen.

Prinzipiell können als zweite Materialien alle Metalle verwendet werden, die einen geringeren Ausdehnungskoeffizient als Kupfer oder die Kupferlegierung aufweisen. Je niedriger der Ausdehnungskoeffizient des zweiten Materials ist und je höher gleichzeitig die Wärmeleitfähigkeit des zweiten Materials ist, umso besser ist dieser Werkstoff als zweites Material geeignet. Die elektrische Leitfähigkeit ist physikalisch mit der thermischen Leitfähigkeit verbunden. Daher sind alle Metalle, die eine gute thermische und/oder elektrische Leitfähigkeit sowie eine niedrige thermische Dehnung besitzen, gut geeignet, um als zweites Material verwendet zu werden bzw. vom zweiten Material umfasst zu sein.

Folgende Tabelle zeigt in Spalte 6 den Ausdehnungskoeffizient des in Spalte 1 aufgeführten Werkstoffes. Alle Werkstoffe, die demnach einen kleineren Ausdehnungskoeffizient als Kupfer aufweisen, sind folglich geeignet, als zweites Material zu dienen bzw. als zweites Material verwendet zu werden.

| | | | | | | | | |
|---|---|---|---|---|---|---|---|---|
| 1) Werkstoff (bzw. Kurzzeichen) | | | | 6) Ausdehnungskoeffizient linear (10^{+6∗}alfa) | | | | |
| 2) Dichte | | | | 7) Spez. Wärme | | | | |
| 3) Elastizitätsmodul | | | | 8) Elektrische Leitfähigkeit | | | | |
| 4) Schmelztemperatur | | | | 9) Temperaturkoeffizient des elektrischen | | | | |
| 5) Wärmeleitfähigkeit | | | | Widerstands (10^{+3∗}alfa) | | | | |

| 1) Werkstoff | 2) Dichte | 3) E. M. | 4) Temp. | 5) WLF | 6) Ausd.k. | 7) sp.W. | 8) El.Leitf. | 9) Temp.K. |
|---|---|---|---|---|---|---|---|---|
| | kg/dm³ | kp/mm² | Grd Celsius | cal/cmsecgrd | m/mgrd | cal/grgrd | m/Ohmmm² | l/grd |
| Silber | 10,49 | 8160 | 960 | 1,00 | 19,7 | 0,056 | 63 | 4,10 |
| Kupfer | 8,96 | 12500 | 1083 | 0,94 | 16,2 | 0,092 | 60 | 4,31 |
| Eisen | 7,87 | 21550 | 1530 | 0,18 | 11,7 | 0,11 | 10,3 | 6,57 |
| Grauguß | 7,20 | 8000-13000 | 1150-1300 | 0,13 | 9,0 | 0,13 | 1-2 | |
| Molybdän | 10,2 | 33630 | 2625 | 0,35 | 5 | 0,061 | 19,4 | 4,73 |
| Monelmetall | 8,58 | 15900 | 1320-1350 | 0,06 | 14 | 0,12 | 1,6 | 0,19 |
| Nickel | 8,90 | 19700 | 1455 | 0,22 | 13,3 | 0,105 | 14,6 | 6,75 |
| Niob | 8,57 | 16000 | 2415 | | 7,0 | 0,0065 | 7,7 | |
| Osmium | 22,5 | 57000 | 2700 | | 4,6 | 0,031 | 10,4 | 4,45 |
| Platin | 21,45 | 17320 | 1774 | 0,17 | 8,9 | 0,032 | 10,2 | 3,92 |
| Stahl C 15 | 7,85 | 20800 | 1510 | 0,12 | 11,1 | 0,11 | 9,3 | 5,7 |
| Stahl C 35 | 7,84 | 20600 | 1490 | 0,12 | 11,1 | 0,11 | 8,6 | 5,2 |
| Stahl C 60 | 7,83 | 20400 | 1470 | 0,11 | 11,1 | 0,11 | 7,9 | 4,7 |
| 41Cr4 | 7,84 | 20700 | 1490 | 0,1 | 11,0 | 0,11 | 8,0 | |
| X10Cr13 | 7,75 | 22000 | 1500 | 0,065 | 10,0 | 0,11 | 1,7 | |
| 36% Ni-Stahl | 8,13 | 14500 | 1450 | 0,025 | 0,9 | 0,123 | | |
| Tantal | 16,6 | 18820 | 3000 | 0,13 | 6,6 | 0,036 | 8,1 | 3,47 |
| Titan | 4,54 | 10520 | 1800 | 0,041 | 10,8 | 0,126 | 1,25 | 5,46 |
| Vanadium | 6,0 | 15000 | 1735 | | 8,5 | 0,12 | 3,84 | |
| Wismut | 9,8 | 3480 | 271 | 0,020 | 12,4 | 0,034 | 0,94 | 4,45 |
| Wolfram | 19,3 | 41530 | 3380 | 0,48 | 4,5 | 0,032 | 18,2 | 4,82 |
| Zirkon | 6,5 | 6970 | 1850 | | 10 | 0,066 | 2,44 | 4,4 |

Das Verbinden der mindestens ersten Kupferschicht oder der mindestens ersten Kupferlegierungsschicht mit der mindestens zweiten Schicht und optional der Verbindungsschicht kann mittels Druckbeaufschlagung, insbesondere mit einem Druck von 5 MPa - 30 MPa, insbesondere von 10 MPa - 28 MPa, insbesondere von 25 MPa, erfolgen.

Eine vorzugsweise durchzuführende Niedertemperatursinterung zur Verbindung der mindestens ersten Kupferschicht oder der mindestens ersten Kupferlegierungsschicht und der mindestens zweiten Schicht und optional der Verbindungsschicht erfolgt vorzugsweise bei Temperaturen von 150 °C - 300 °C und bei einem beaufschlagten Druck von 5 MPa - 30 MPa. Besonders bevorzugt wird die Niedertemperatursinterung bei einer Temperatur von 250 °C und einem Druck von 25 MPa durchgeführt, wobei die Sinterung vorzugsweise 1 bis 10 min, beispielsweise 4 min, lang durchgeführt wird.

Die Verbindungstemperatur beim Verfahren zur Herstellung eines Schaltungsträgers entspricht im Wesentlichen der Montagetemperatur bei der Verbindung des hergestellten Schaltungsträgers mit mindestens einem Halbleiterbaustein. Die Verbindungstemperatur kann exakt der Montagetemperatur entsprechen. Des Weiteren ist es möglich, dass die Verbindungstemperatur höchstens 20 %, insbesondere höchstens 15 %, insbesondere höchstens 10 %, insbesondere höchstens 5 %, von der Montagetemperatur abweicht. Die prozentuale Berechnung der Abweichung der Verbindungstemperatur von der Montagetemperatur erfolgt aufgrund einer Berechnung der Differenz zwischen der Verbindungstemperatur in Kelvin und der Montagetemperatur in Kelvin.

Neben dem Durchführen eines Niedertemperatursinterverfahrens ist es außerdem möglich, die einzelnen Schichten des Schaltungsträgers durch Diffusionslöten mit der Ausbildung hochschmelzender intermetallischer Phasen miteinander zu verbinden. Auch die Verwendung von Klebstoffen zur Verbindung der einzelnen Schichten des Schaltungsträgers ist möglich.

Vorzugsweise wird das Verbindungsmaterial als Sintermaterial bzw. Bestandteil des Sintermaterials zwischen die mindestens erste Kupferschicht oder die mindestens erste Kupferlegierungsschicht und die mindestens zweite Schicht eingebracht. Eine zu einer leitfähigen Schicht sinterfähige Zusammensetzung kann demnach zur Herstellung einer Sinterverbindung zwischen den zu verbindenden Schichten verwendet werden. Die noch sinterfähige Zusammensetzung kann die Anwendungsform einer Tinte, einer Paste oder einer Sinter-Vorform in Form eines schichtförmigen Presslings besitzen. Sinter-Vorformen bzw. sogenannte Sinter-Preforms entstehen durch Applikation und Trocknung von Metallpasten bzw. Metallsinterpasten. Derartige Sinter-Vorformen sind noch sinterfähig.

Alternativ ist es möglich, dass das Verbindungsmaterial als Folie, insbesondere als Metallfolie, ausgebildet ist und diese Folie, insbesondere diese Metallfolie, zwischen der ersten Kupferschicht oder der ersten Kupferlegierungsschicht und der zweiten Schicht angeordnet wird.

Es ist möglich, dass die Sinterpaste, die das Verbindungsmaterial umfasst bzw. aus dem Verbindungsmaterial besteht, durch Drucken, insbesondere Sieb- oder Schablonendrucken, auf die erste Kupferschicht oder erste Kupferlegierungsschicht und/oder die zweite Schicht aufgebracht wird. Mit anderen Worten wird die Sinterpaste auf eine erste Kupferschicht, sofern diese vorhanden ist, oder auf eine erste Kupferlegierungsschicht, sofern diese vorhanden ist, und/oder auf die zweite Schicht aufgebracht.

Optional kann die Sinterpaste bzw. die Metallsinterpaste vor dem Durchführen des eigentlichen Sinterverfahrens getrocknet werden. Ohne den flüssigen Zustand zu durchlaufen, verbinden sich die Metallteilchen der Sinterpaste während des Sinterns durch Diffusion unter Ausbildung einer festen, elektrischen Strom- und Wärme-leitenden metallischen Verbindung bzw. Metallverbindung zwischen der mindestens ersten Kupferschicht oder der mindestens ersten Kupferlegierungsschicht und der mindestens zweiten Schicht. Besonders bevorzugt wird beim Verbinden der Schichten eine Sinterpaste verwendet, die Silber und/oder eine Silberlegierung und/oder Silbercarbonat und/oder Silberoxid umfasst.

In einer weiteren Ausführungsform der Erfindung ist es möglich, dass auf die mindestens erste Kupferschicht oder auf die mindestens erste Kupferlegierungsschicht und/oder auf die mindestens zweite Schicht, vorzugsweise auf die zweite Schicht, vor dem Aufbringen einer Verbindungsschicht, eine, beispielsweise durch Galvanik oder Sputtern aufgebrachte, Schicht zur besseren Anbindung der Verbindungsschicht bzw. Fügeschicht aufgetragen wird. Sofern es sich bei der zweiten Schicht um eine Molybdän-Schicht handelt bzw. das zweite Material der zweiten Schicht Molybdän umfasst, kann auf die zu verbindende Seite der zweiten Schicht eine Nickel-Silber-Schicht (NiAg-Schicht) galvanisch aufgebracht werden. Auf dieser Nickel-Silber-Schicht kann das Verbindungsmaterial, insbesondere Silber, besonders gut haften.

Die Erfindung beruht in einem nebengeordneten Aspekt des Weiteren auf dem Gedanken, einen Schaltungsträger, insbesondere ein Stanzgitter oder eine Leiterbahn, für einen Halbleiterbaustein anzugeben, wobei der Schaltungsträger vorzugsweise mit einem vorerwähnten erfindungsgemäßen Verfahren hergestellt ist.

Der erfindungsgemäße Schaltungsträger umfasst:
- mindestens eine erste Kupferschicht oder eine erste Kupferlegierungsschicht mit einem ersten Ausdehnungskoeffizient,
   und
- mindestens eine zweite Schicht aus einem zweiten, dehnungsarmen Material mit einem zweiten Ausdehnungskoeffizient, der kleiner als der erste Ausdehnungskoeffizient ist, wobei das zweite Material eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), besonders bevorzugt Molybdän (Mo), aufweist.

In einer besonders bevorzugten Ausführungsform der Erfindung umfasst das zweite Material Molybdän (Mo) oder das zweite Material ist Molybdän (Mo). Es ist auch möglich, dass das zweite Material eine Molybdänlegierung umfasst oder eine Molybdänlegierung ist.

Zwischen der ersten Kupferschicht oder der ersten Kupferlegierungsschicht und der zweiten Schicht kann mindestens eine erste Verbindungsschicht ausgebildet sein, die vorzugsweise Diffusionsmetall, insbesondere Silber (Ag) und/oder eine Silberlegierung und/oder Gold (Au) und/oder eine Goldlegierung und/oder Kupfer (Cu) und/oder eine Kupferlegierung, umfasst.

Die mindestens erste Verbindungsschicht kann als Grenzschicht der ersten Kupferschicht oder der ersten Kupferlegierungsschicht und/oder der zweiten Schicht ausgebildet sein.

Es ist möglich, dass die Verbindungsschicht eine selbstständige sichtbare Schicht ist. Sofern das Verbindungsmaterial beim Herstellen des erfindungsgemäßen Schaltungsträgers lediglich mit einer geringeren Schichtdicke aufgetragen ist, kann die Verbindungsschicht im hergestellten Produkt, nämlich in dem hergestellten Schaltungsträger, als Grenzschicht der ersten Kupferschicht oder der ersten Kupferlegierungsschicht und/oder der zweiten Schicht ausgebildet sein. Das Verbindungsmaterial kann beispielsweise in die erste Kupferschicht oder die erste Kupferlegierungsschicht und/oder die zweite Schicht zumindest abschnittsweise eindiffundiert sein.

Besonders bevorzugt handelt es sich bei dem Verbindungsmaterial der Verbindungsschicht um Silber oder um eine Silberlegierung, so dass das Silber bzw. die Silberlegierung bei der Ausbildung der Verbindungsschicht als Grenzschicht in die erste Kupferschicht oder die erste Kupferlegierungsschicht und/oder die zweite Schicht abschnittsweise eindiffundiert ist.

In einer weiteren Ausführungsform der Erfindung weist der Schaltungsträger mindestens eine zweite Kupferschicht oder eine zweite Kupferlegierungsschicht auf, die vorzugsweise mittels einer zweiten Verbindungsschicht aus einem/dem Verbindungsmaterial mit der zweiten Schicht aus dem zweiten, dehnungsarmen Material verbunden ist. Der Schaltungsträger kann demnach drei Schichten umfassen, die mit Hilfe von zwei Verbindungsschichten miteinander verbunden sind.

In einer weiteren Ausführungsform der Erfindung kann der Schaltungsträger mindestens eine vierte Schicht aufweisen, die aus einem/dem zweiten Material gebildet ist. Die vierte Schicht ist vorzugsweise mittels einer dritten Verbindungsschicht aus einem/dem Verbindungsmaterial mit einer Kupferschicht oder einer Kupferlegierungsschicht verbunden. In dieser Ausführungsform der Erfindung umfasst der Schaltungsträger vier Schichten, die entweder aus Kupfer bzw. einer Kupferlegierung oder aus einem/dem zweiten Material gebildet sind, wobei diese vier Schichten durch mindestens drei Verbindungsschichten miteinander verbunden sind.

In einer weiteren Ausführungsform der Erfindung kann der Schaltungsträger mindestens eine dritte Kupferschicht oder eine dritte Kupferlegierungsschicht aufweisen. Die dritte Kupferschicht oder dritte Kupferlegierungsschicht kann mit einer Kupferschicht oder Kupferlegierungsschicht verbunden sein. Auch diese Verbindung kann mittels einer Verbindungsschicht aus einem/dem Verbindungsmaterial hergestellt werden.

Der Schaltungsträger kann eine symmetrische Anordnung der einzelnen Schichten und Verbindungsschicht(en) aufweisen. Vorzugsweise ist die symmetrische Anordnung der einzelnen Schichten und Verbindungsschicht(en) derart ausgebildet, dass ein planer Schaltungsträger gebildet ist. Eine symmetrische Anordnung der einzelnen Schichten ist derart zu verstehen, dass bei einem theoretischen Ausbilden einer Symmetrieachse durch den Schaltungsträger, sowohl oberhalb als auch unterhalb der Symmetrieachse eine symmetrische Anordnung der einzelnen Schichten und Verbindungsschicht(en) mit übereinstimmenden Materialien und Schichtdicken ausgebildet ist. Die Symmetrieachse halbiert die Anordnung der einzelnen Schichten bezüglich der Gesamtdicke des Schaltungsträgers, wobei die Gesamtdicke des Schaltungsträgers durch die Addierung der einzelnen Schichtdicken gebildet wird.

Bei der Ausbildung einer symmetrischen Anordnung der einzelnen Schichten und Verbindungsschicht(en) ist es möglich, einen planen Schaltungsträger zu bilden.

Bei einzelnen Anwendungen ist es notwendig, dass die Oberfläche, auf welcher mindestens ein Halbleiterbaustein aufgebracht wird, vollkommen plan ist. Dies verhindert beispielsweise ein Verlaufen von Kontaktierungsmaterial und somit ein "Abrutschen" eines mittels des Kontaktierungsmaterials mit dem Schaltungsträger verbundenen Halbleiterbausteins.

In einer alternativen Ausführungsform der Erfindung ist es möglich, dass die einzelnen Schichten und Verbindungsschicht(en) asymmetrisch angeordnet sind. Die einzelnen Schichten und Verbindungsschicht(en) sind insbesondere derart asymmetrisch angeordnet, dass ein konvex oder konkav geformter Schaltungsträger gebildet ist. Ein konvex oder konkav geformter Schaltungsträger kann auch als Schaltungsträger mit Balligkeit bzw. mit einer balligen Seite bezeichnet werden. Vorzugsweise weist der Schaltungsträger eine gesteuerte konvexe oder konkave Form auf. Mit anderen Worten ist das Balligkeits-Maximum definiert.

Eine asymmetrische Anordnung ist durch eine theoretisch gebildete Symmetrieachse sichtbar. Die Symmetrieachse halbiert die Gesamtdicke der Anordnung der einzelnen Schichten, wobei die Gesamtdicke durch die Addierung der einzelnen Schichtdicken des Schaltungsträgers definiert ist. Vorzugsweise wird die Balligkeit bzw. die konvexe oder konkave Form des Schaltungsträgers durch Anordnung und/oder Ausbildung der zweiten Schicht und/oder der mindestens vierten Schicht aus einem/dem zweiten Material, nämlich dem dehnungsarmen Material, gesteuert. Vorzugsweise wird bzw. werden die zweite Schicht und/oder die mindestens vierte Schicht in Relation zur Gesamtanordnung aller Schichten und Verbindungsschicht(en) asymmetrisch ausgebildet, so dass sich gezielt eine Symmetrieachse aus der Dehnung des hergestellten Schaltungsträgers ergibt.

In Abhängigkeit des Anwendungsfalles kann durch Position und/oder Ausbildung der zweiten Schicht und/oder der mindestens vierten Schicht aus einem dehnungsarmen zweiten Material nach finaler Abkühlung ein balliger Schaltungsträger erzielt werden. Hierzu wird der erfindungsgemäße Schaltungsträger mit Hilfe des vorerwähnten erfindungsgemäßen Verfahrens hergestellt und mit dem noch nacherwähnten erfindungsgemäßen Verfahren zur Herstellung eines Halbleitermoduls mit mindestens einem Halbleiterbaustein verbunden.

In einer weiteren Ausführungsform der Erfindung kann die zweite Schicht aus einem zweiten, dehnungsarmen Material in einer Kupferschicht oder einer Kupferlegierungsschicht eingebettet sein. Bei der Kupferschicht oder Kupferlegierungsschicht kann es sich beispielsweise um die erste Kupferschicht bzw. erste Kupferlegierungsschicht oder um die zweite Kupferschicht oder zweite Kupferlegierungsschicht handeln.

In einer weiteren Ausführungsform der Erfindung ist die zweite Schicht aus einem zweiten, dehnungsarmen Material rahmenartig und/oder gitterartig und/oder drahtartig ausgebildet. Vorzugsweise erfolgt diese Ausbildung der zweiten Schicht und/oder einer vierten Schicht in Kombination mit dem Einbetten der jeweiligen Schicht in eine Kupferschicht oder eine Kupferlegierungsschicht. Des Weiteren ist es möglich, dass die zweite Schicht aus einem zweiten, dehnungsarmen Material eine geringere Breite bzw. Länge als die darüber und/oder darunter angeordnete Kupferschicht oder Kupferlegierungsschicht aufweist.

Sofern die zweite Schicht gitterartig und/oder drahtartig ausgebildet ist, können in verbesserter Art und Weise Scherspannungen zwischen der zweiten Schicht aus einem dehnungsarmen Material und einer darüber und/oder darunter befindlichen Kupferschicht oder Kupferlegierungsschicht aufgenommen werden. In den Zwischenräumen der Drähte bzw. des Gitters kann sich Verbindungsmaterial, insbesondere Lot oder Sintermaterial oder leitfähiger Kleber, befinden. Außerdem ist es möglich, dass sich in den Zwischenräumen der Drähte bzw. des Gitters Kupfer oder einer Kupferlegierung befindet. In dieser Ausführungsform kann beispielsweise eine unterhalb der zweiten Schicht ausgebildete Kupferschicht oder Kupferlegierungsschicht in die Zwischenräume der Drähte bzw. des Gitters während des Verbindens der Schichten gepresst werden.

Der erfindungsgemäße Schaltungsträger trägt erfindungsgemäß zu einer maximalen Entwärmung eines mit dem Schaltungsträger verbundenen Halbleiterbausteins im Betrieb bei. Die Leistungsfähigkeit sowie die Betriebsdauer des Halbleiterbausteins wird aufgrund eines erfindungsgemäßen Schaltungsträgers maximiert.

Die Erfindung beruht in einem nebengeordneten Aspekt des Weiteren auf dem Gedanken, ein Verfahren zur Herstellung eines Halbleitermoduls, das einen Schaltungsträger und mindestens einen Halbleiterbaustein, der mit dem Schaltungsträger verbunden ist, umfasst, anzugeben. Vorzugsweise handelt es sich bei dem Schaltungsträger um einen vorerwähnten erfindungsgemäßen Schaltungsträger oder um einen Schaltungsträger, der mit einem vorerwähnten erfindungsgemäßen Verfahren hergestellt wurde.

Das erfindungsgemäße Verfahren zur Herstellung eines Halbleitermoduls beruht darauf, dass der Halbleiterbaustein mittels einer Kontaktierungsschicht mit dem Schaltungsträger bei einer Montagetemperatur von 150 °C - 300 °C verbunden wird, wobei die Montagetemperatur im Wesentlichen der Verbindungstemperatur bei der Verbindung von/der Schichten des Schaltungsträgers entspricht.

Die Montagetemperatur kann exakt der Verbindungstemperatur entsprechen. Vorzugsweise weicht die Montagetemperatur höchstens 20 %, insbesondere höchstens 15 %, insbesondere höchstens 10 %, insbesondere höchstens 5 %, von der Verbindungstemperatur ab. Die prozentuale Berechnung der Abweichung der Montagetemperatur von der Verbindungstemperatur erfolgt aufgrund einer Berechnung der Differenz zwischen der Montagetemperatur in Kelvin und der Verbindungstemperatur in Kelvin.

Die Montagetemperatur kann 200 °C - 280 °C, insbesondere 220 °C - 270 °C, insbesondere 240 °C - 260 °C, insbesondere 250 °C, betragen.

Der Halbleiterbaustein wird vorzugsweise auf die Oberfläche des Schaltungsträgers aufgebracht bzw. mit der Oberfläche des Schaltungsträgers verbunden, wobei die Oberfläche vorzugsweise von einer Kupferschicht oder einer Kupferlegierungsschicht gebildet ist. Die Oberfläche kann auch als oberste Seite des Schaltungsträgers bezeichnet werden.

Bei der Kontaktierungsschicht kann es sich beispielsweise um eine Sinterpaste handeln. Es ist auch möglich, dass es sich bei der Kontaktierungsschicht um eine Klebeschicht oder um eine Lotschicht handelt.

In einer Ausführungsform der Erfindung können die Verbindung der Schichten des Schaltungsträgers und die Verbindung des Halbleiterbausteins mit dem Schaltungsträger gleichzeitig erfolgen. In dieser Ausführungsform werden alle Schichten, Verbindungsschicht(en) sowie der zu verbindende Halbleiterbaustein übereinander angeordnet und beispielsweise mittels eines Niedertemperatursinterverfahrens zur gleichen Zeit miteinander verbunden.

Durch Kombination des erfindungsgemäßen Verfahrens zur Herstellung eines Schaltungsträgers mit dem erfindungsgemäßen Verfahren zur Herstellung eines Halbleitermoduls, ist es möglich, einen Schaltungsträger mit asymmetrischer Anordnung der Schichten und Verbindungsschicht(en) derart herzustellen, dass eine definierte konvexe oder konkave Verformung des Schaltungsträgers, mit anderen Worten ein definiertes Balligkeits-Maximum erzeugt wird. Die einzelnen Schichten und Verbindungsschicht(en) werden asymmetrisch zueinander angeordnet. Die Asymmetrie kann durch die Anzahl der Schichten und/oder durch die Schichtdicken gesteuert werden.

Die asymmetrische Anordnung von Schichten und Verbindungsschicht(en) wird bei einer Verbindungstemperatur miteinander verbunden, die im Wesentlichen der Montagetemperatur des Halbleiterbausteins mit dem Schaltungsträger entspricht.

Es folgt die Verbindung des Halbleiterbausteins mit dem Schaltungsträger. Hierbei zeigt sich, dass sich die konkave oder konvexe Verformung bei Wiedererwärmung des hergestellten asymmetrischen Schaltungsträgers zurückbildet und nach der Verbindung des Halbleiterbausteins mit der Substratplatte in einem neuen Spannungsgleichgewicht in anforderungsgerechter Weise eine temperaturstabile Endgestalt einnimmt. Bei der temperaturstabilen Endgestalt kann es sich um ein definiertes Balligkeits-Maximum handeln. Beispielsweise beträgt ein definiertes Balligkeits-Maximum 100 µm. Bei der temperaturstabilen Endgestalt kann es sich außerdem um ein vollständig planes Halbleitermodul handeln.

Die Erfindung beruht des Weiteren auf dem Gedanken, ein Halbleitermodul anzugeben, wobei das Halbleitermodul vorzugsweise mit einem vorerwähnten erfindungsgemäßen Verfahren hergestellt ist. Das Halbleitermodul umfasst einen Schaltungsträger und mindestens einen Halbleiterbaustein, der mit dem Schaltungsträger verbunden ist. Bei dem Schaltungsträger handelt es sich vorzugsweise um einen erfindungsgemäßen Schaltungsträger oder um einen Schaltungsträger, der mittels eines vorerwähnten erfindungsgemäßen Verfahrens hergestellt ist.

Bei dem Halbleiterbaustein kann es sich um eine Diode oder einen IGBT (Bipolartransistor mit isolierter Gate-Elektrode) oder um einen MOSFET-Transistor handeln. Vorzugsweise handelt es sich bei dem Halbleiterbaustein um einen Leistungshalbleiter.

Die zweite Schicht des Schaltungsträgers ist gemäß einer bevorzugten Ausführungsform des erfindungsgemäßen Halbleitermoduls in einer Kupferschicht oder einer Kupferlegierungsschicht eingebettet, wobei der Halbleiterbaustein oberhalb der zweiten Schicht ausgebildet ist. Bei einer derartigen Ausbildung der zweiten Schicht in dem Halbleitermodul, ist die Fläche der zweiten Schicht wesentlich geringer als die Fläche der mindestens einen Kupferschicht oder der mindestens einen Kupferlegierungsschicht. Vorzugsweise ist die Fläche der zweiten Schicht nicht geringer als 80 % der Fläche des Halbleiterbausteins. Als "oberhalb" ist in diesem Fall eine Position des Halbleiterbausteins in vertikaler Verlängerung zur zweiten Schicht zu verstehen. Zwischen der zweiten Schicht und dem Halbleiterbaustein kann sich noch eine weitere Schicht befinden.

Vorzugsweise besitzt die zweite Schicht das gleiche Seitenverhältnis wie der darüber angeordnete Halbleiterbaustein. Die erzielte Reduzierung der Fläche der zweiten Schicht gegenüber der Fläche der Kupferschicht oder Kupferlegierungsschicht reduziert die Dehnungsfehlanpassung konzentriert und lokal im Bereich des geringdehnenden Halbleiterbausteins. Im Schaltungsträger wird ein Abschnitt gebildet, der keine zweite Schicht aufweist bzw. mit anderen Worten frei von der zweiten Schicht ist. In diesem Abschnitt befindet sich lediglich Kupfer bzw. eine Kupferlegierung. In einer derartigen Ausführungsform des Halbleitermoduls ist eine besonders hohe z-Wärmeleitfähigkeit gegeben. Als z-Wärmeleitfähigkeit ist die Wärmeleitfähigkeit ausgehend vom Halbleiterbaustein in Richtung der darunter befindlichen Schichten des Schaltungsträgers zu verstehen.

Der Halbleiterbaustein kann deckungsgleich zur zweiten Schicht ausgebildet sein.

In einer weiteren Ausführungsform der Erfindung kann die zweite Schicht in einer Kupferschicht oder einer Kupferlegierungsschicht eingebettet sein, wobei die zweite Schicht rahmenartig ausgebildet ist und einen Kupferschichtabschnitt oder einen Kupferlegierungsschichtabschnitt umrahmt, wobei der Halbleiterbaustein oberhalb des Kupferschichtabschnitts oder Kupferlegierungsschichtabschnitts ausgebildet ist. Als "oberhalb" ist in diesem Fall eine Position des Halbleiterbausteins in vertikaler Verlängerung zur zweiten Schicht zu verstehen. Zwischen der zweiten Schicht und dem Halbleiterbaustein kann sich noch eine weitere Schicht befinden.

Es ist möglich, dass die Kantenlängen des Kupferschichtabschnitts oder Kupferlegierungsschichtabschnitts maximal 150 % der Kantenlängen des Halbleiterbausteins betragen. Die Breite der rahmenartig ausgebildeten zweiten Schicht beträgt vorzugsweise 10 % - 100 % der kürzesten Kantenlänge des Halbleiterbausteins. Die rahmenartige Ausbildung der zweiten Schicht aus dehnungsarmem Material bewirkt eine Dehnungsreduzierung innerhalb des Halbleitermoduls. Der umschlossene Kupferlegierungsschichtabschnitt bzw. Kupferschichtabschnitt bewirkt hingegen eine maximale z-Wärmeleitfähigkeit aufgrund des Kupfermaterials bzw. Kupferlegierungsmaterials.

In einer weiteren Ausführungsform der Erfindung ist die Flächengröße der zweiten Schicht, die vorzugsweise zwischen mindestens zwei Kupferschichten und/oder Kupferlegierungsschichten ausgebildet ist, auf eine zur Verteilung der mechanischen Scherspannung zwischen dem Halbleiterbaustein und dem Schaltungsträger angepasste Gestalt beschränkt. Oftmals ist die Scherspannung zwischen dem Halbleiterbaustein und dem Schaltungsträger entlang der Diagonalen des Halbleiterbausteins besonders groß. Die Scherspannungen können sich außerdem über die Diagonalen hinaus erstrecken. Die Scherspannungsverteilung ist im Wesentlichen punktsymmetrisch zum geometrischen Zentrum des Halbleiterbausteins.

Eine minimierte Fläche der zweiten Schicht aus dehnungsarmem Material ist demzufolge eine Fläche, die sich in den Diagonalen des Halbleiterbausteins anteilig weiter erstreckt als im Bereich der Koordinatenachsen des Halbleiterbausteins. Mit anderen Worten weist die zweite Schicht eine Flächenform auf, so dass die Erstreckung im Bereich der Diagonalen des Halbleiterbausteins größer ist als im Bereich der Koordinatenachsen des Halbleiterbausteins. Die gebildete Flächenform der zweiten Schicht ähnelt einem vierblättrigen Kleeblatt. Mittig der Fläche der zweiten Schicht kann ein Kupferschichtabschnitt oder ein Kupferlegierungsschichtabschnitt ausgebildet sein, der in die zweite Schicht eingebettet ist. Eine derartige Ausbildung eines Halbleitermoduls verbessert die Wärmeleitfähigkeit durch den Verzicht auf dehnungsarmes Material und aufgrund der Verwendung von Kupfer oder einer Kupferlegierung.

Die Erfindung wird nachfolgend mit weiteren Einzelheiten unter Bezugnahme auf die beigefügten schematischen Zeichnungen anhand von Ausführungsbeispielen näher erläutert. In diesen zeigen:
- Fig. 1a: die Anordnung einzelner Schichten eines Schaltungsträgers;
- Fig. 1b: Schaltungsträger gemäß Fig. 1a im verbundenen Zustand;
- Fig. 2: ein Halbleitermodul gemäß einem ersten Ausführungsbeispiel;
- Fig. 3: ein Halbleitermodul gemäß einem zweiten Ausführungsbeispiel;
- Fig. 4: ein Halbleitermodul gemäß einem dritten Ausführungsbeispiel;
- Fig. 5: ein Halbleitermodul gemäß einem vierten Ausführungsbeispiel;
- Fig. 6: ein Halbleitermodul gemäß einem fünften Ausführungsbeispiel; und
- Fig. 7: ein Halbleitermodul gemäß einem sechsten Ausführungsbeispiel.

Im Folgenden werden für gleiche und gleichwirkende Teile gleiche Bezugsziffern verwendet.

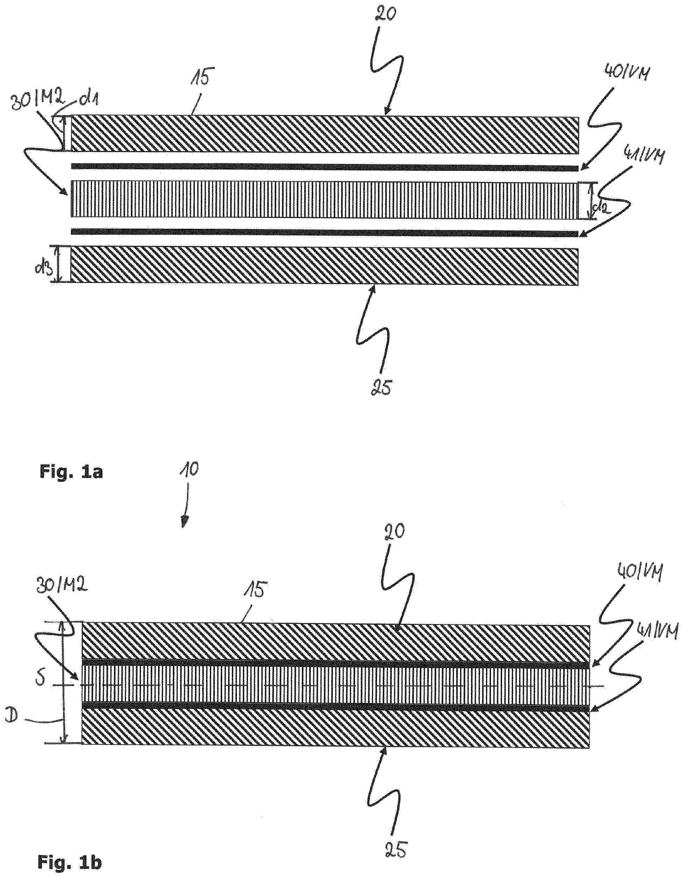

In Fig. 1a sind die einzelnen Schichten eines herzustellenden Schaltungsträgers 10 (siehe Fig. 1b) dargestellt. Demnach umfasst der herzustellende Schaltungsträger 10 eine erste Schicht 20 aus Kupfer, eine zweite Schicht 30 aus einem zweiten Material M2 sowie eine zweite Kupferschicht 25.

Das Material M2 ist ein dehnungsarmes Material mit einem zweiten Ausdehnungskoeffizient, der kleiner als der Ausdehnungskoeffizient von Kupfer ist. Bei dem zweiten Material M2 kann es sich um eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung) handeln. Im vorliegenden Ausführungsbeispiel handelt es sich bei dem Material M2 um Molybdän.

Zwischen der ersten Kupferschicht 20 und der zweiten Schicht 30 ist eine erste Verbindungsschicht 40 aus einem Verbindungsmaterial VM ausgebildet. Zwischen der zweiten Schicht 30 und der zweiten Kupferschicht 25 ist eine zweite Verbindungsschicht 41 aus dem Verbindungsmaterial VM ausgebildet. Das Verbindungsmaterial VM der Verbindungsschichten 40 und 41 schafft eine Verbindung zwischen den Schichten 20, 25 und 30, die Temperaturen oberhalb einer Verbindungstemperatur standhält. Vorzugsweise weist die Verbindungsschicht Diffusionsmaterial, insbesondere Silber und/oder eine Silberlegierung und/oder Gold und/oder eine Goldlegierung und/oder Kupfer und/oder eine Kupferlegierung, auf.

Vorzugsweise ist die Verbindungsschicht als Sinterschicht, insbesondere als Sinterpaste ausgebildet. Diese Sinterpaste, die vorzugsweise eines der aufgeführten Diffusionsmetalle aufweist, kann beispielsweise mittels eines Druckverfahrens aufgebracht werden.

Vorzugsweise werden die Schichten 20, 25, 30, 40 und 41 bei einer Verbindungstemperatur von 150 °C - 300 °C durch ein Niedertemperatursinterverfahren miteinander verbunden. Besonders bevorzugt beträgt die Verbindungstemperatur 250 °C. Die Verbindungstemperatur zur Verbindung der Schichten 20, 25 und 30 mit Hilfe der Verbindungsschichten 40 und 41 entspricht im Wesentlichen der Montagetemperatur bei der Verbindung des hergestellten Schaltungsträgers 10 mit einem aufzubringenden Halbleiterbaustein.

Das Verbinden der ersten Kupferschicht 20 mit der zweiten Schicht 30 sowie mit der zweiten Kupferschicht 25 erfolgt vorzugsweise mittels Druckbeaufschlagung, insbesondere mit einem Druck von 5 MPa - 30 MPa, insbesondere von 25 MPa.

In Fig. 1b ist der hergestellte Schaltungsträger 10 zu erkennen. In diesem sind die Verbindungsschichten 40 und 41 zu erkennen. Es ist möglich, dass die Verbindungsschichten 40 und 41 als Grenzschichten der ersten Kupferschicht 20, der zweiten Kupferschicht 25 sowie der zweiten Schicht 30 ausgebildet sind.

Wie in den Fig. 1a und 1b zu erkennen ist, sind die Schichtdicken d1 der ersten Kupferschicht 20, d2 der zweiten Schicht 30 sowie d3 der zweiten Kupferschicht 25 gleich. Mit Hilfe der in Fig. 1b eingezeichneten Symmetrieachse S wird ersichtlich, dass es sich bei dem Aufbau des Schaltungsträgers 10 um einen symmetrischen Aufbau der einzelnen Schichten 20, 25 und 30 sowie der Verbindungsschichten 40 und 41 handelt. Die Symmetrieachse S halbiert die Gesamtdicke D des Schaltungsträgers 10. Die Gesamtdicke D wird durch Addition der Schichtdicken d1, d2 und d3 sowie der Schichtdicken der Verbindungsschichten 40, 41 gebildet. Oberhalb und unterhalb der Symmetrieachse S zeigt sich ein symmetrischer Aufbau des Schaltungsträgers 10.

In einer bevorzugten Ausführungsform beträgt die Schichtdicke d1 der ersten Kupferschicht 20 0,5 mm - 3,0 mm, die Schichtdicke d2 der zweiten Schicht 30 0,1 mm - 1,0 mm und die Schichtdicke d3 der zweiten Kupferschicht 25 0,5 mm - 3,0 mm. Die Dicken der ersten Verbindungsschicht und zweiten Verbindungsschicht betragen vorzugsweise 1 µm - 50 µm.

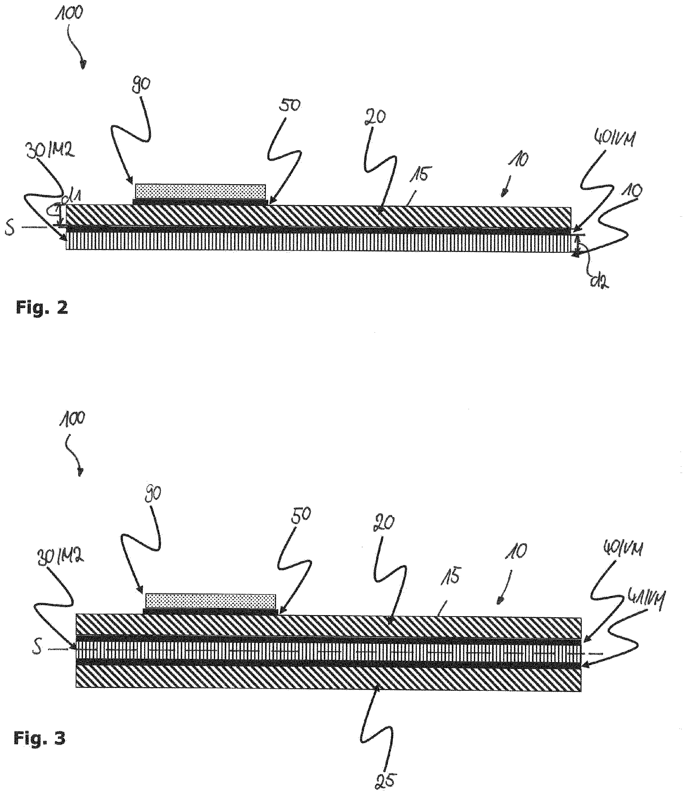

In Fig. 2 ist ein Halbleitermodul 100 dargestellt. Das Halbleitermodul 100 umfasst einen Halbleiterbaustein 90 sowie einen Schaltungsträger 10. Bei dem Halbleiterbaustein 90 kann es sich beispielsweise um eine Diode oder einen IGBT oder einen MOSFET-Transistor handeln. Der Halbleiterbaustein 90 ist mittels einer Kontaktierungsschicht 50 mit dem Schaltungsträger 10 verbunden. Bei der Kontaktierungsschicht 50 kann es sich beispielsweise um eine Lotschicht oder eine elektrisch leitende Klebeschicht oder um eine Sinterschicht handeln.

Der dargestellte Schaltungsträger 10 besteht aus einer ersten Kupferschicht 20 sowie einer zweiten Schicht 30 aus zweitem Material M2. Bei dem zweiten Material M2 handelt es sich um Molybdän. Die erste Schicht 20 ist mittels einer Verbindungsschicht 40, die aus Verbindungsmaterial VM besteht, mit der zweiten Schicht 30 verbunden.

Der Halbleiterbaustein 90 wird mit Hilfe der Kontaktierungsschicht 50 auf die dem Halbleiterbaustein 90 zugewandte Seite 15 des Schaltungsträgers 10 aufgebracht. Bei der mit dem Halbleiterbaustein 90 zu verbindenden Oberfläche 15 des Schaltungsträgers 10 handelt es sich um die erste Seite 15 der ersten Kupferschicht 20, wobei die erste Seite 15 der Kupferschicht 20 von der zweiten Schicht 30 abgewandt ausgebildet ist.

Die angedeutete Symmetrieachse S zeigt, dass in der Ausführungsform gemäß Fig. 2 eine asymmetrische Anordnung der Schichten 20, 30 und 40 vorliegt. Die Schichtdicke d1 der ersten Kupferschicht 20 ist größer als die Schichtdicke d2 der zweiten Schicht 30.

In Fig. 3 ist ein Halbleitermodul 100 gemäß einem zweiten Ausführungsbeispiel dargestellt. Bei dem Schaltungsträger 10 der Fig. 3 handelt es sich um den in Fig. 1b dargestellten Schaltungsträger 10, also um einen Schaltungsträger 10 mit symmetrischer Anordnung. Auch in dieser Ausführungsform ist das Halbleiterbauteil 90 mittels einer Kontaktierungsschicht 50 auf der ersten Seite 15 der ersten Kupferschicht 20 aufgebracht.

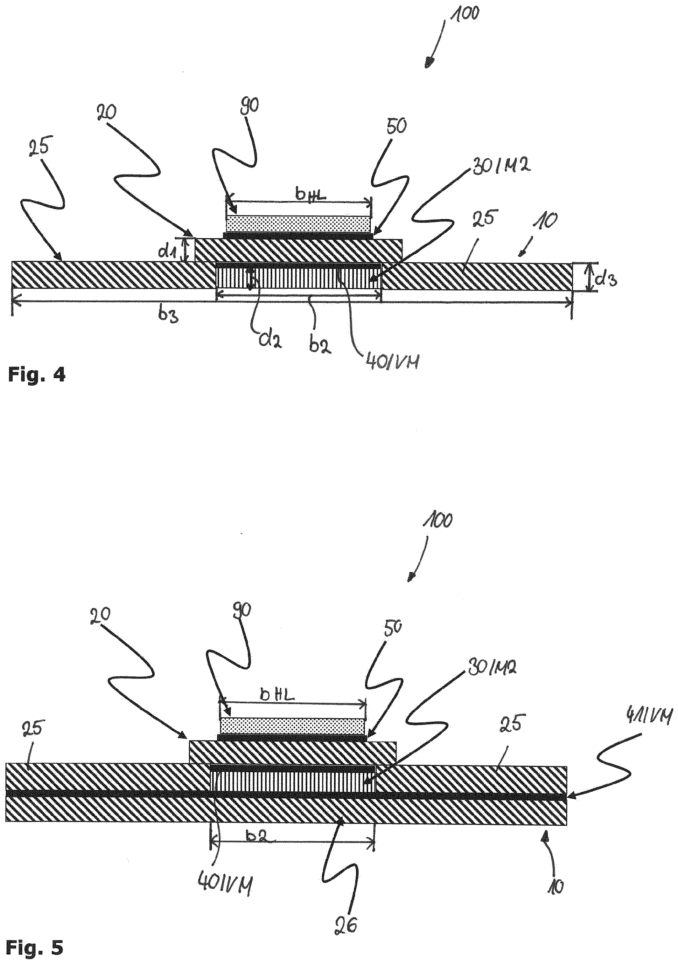

In Fig. 4 wird ein weiteres Ausführungsbeispiel hinsichtlich eines Schaltungsträgers 10 eines erfindungsgemäßen Halbleitermoduls 100 dargestellt. Demnach ist die zweite Schicht 30 aus zweitem Material M2, insbesondere aus Molybdän, in die zweite Kupferschicht 25 eingebettet. Sowohl die Breite b2 der zweiten Schicht 30 als auch die Dicke d2 der zweiten Schicht 30 ist geringer als die Breite b3 der zweiten Kupferschicht 25 und die Dicke d3 der zweiten Kupferschicht 25. Der Halbleiterbaustein 90 ist oberhalb der zweiten Schicht 30 auf dem Schaltungsträger 10 montiert. Die Breite b2 der zweiten Schicht ist dabei geringfügig größer als die Breite bHL des Halbleiterbausteins 90.

Der Schaltungsträger 10 umfasst eine erste Kupferschicht 20, die abschnittsweise oberhalb der zweiten Kupferschicht 25 und oberhalb der zweiten Schicht 30 angeordnet ist. Zur Verbindung der ersten Kupferschicht 20 mit der zweiten Schicht 30 ist zwischen der ersten Kupferschicht 20 und der zweiten Schicht 30 aus zweitem Material M2 eine Verbindungsschicht 40 aus Verbindungsmaterial VM ausgebildet.

Da die Schichtdicke d2 der zweiten Schicht 30 geringer ist als die Schichtdicke d3 der zweiten Kupferschicht 25, kann die erste Verbindungsschicht 40 beispielsweise mittels eines Rakels in die aufgrund der unterschiedlichen Schichtdicken d2 und d3 gebildete Ausnehmung eingebracht werden. Vorzugsweise handelt es sich bei der ersten Kupferschicht 20 um eine Kupferleiterbahn.

Ein erfindungsgemäßes Verfahren zum Herstellen des Schaltungsträgers 10 bzw. des Halbleitermoduls 100 sieht zunächst vor, dass die zweite Schicht 30 mit der ersten Kupferschicht 20 beispielsweise durch ein Niedertemperatursinterverfahren verbunden wird. Aufgrund des asymmetrischen Aufbaus des Schaltungsträgers 10 entsteht zunächst eine Verformung bei Abkühlung des Schaltungsträgers 10 auf Raumtemperatur. Wird nun in einem zweiten Arbeitsgang, insbesondere durch Sintern, Diffusionslöten oder Kleben, das Halbleiterelement 90 auf dem Schaltungsträger 10 montiert, entsteht ein mechanischer Spannungsausgleich, der wiederum zu einer ebenen Leiterbahnausprägung führt.

Diese Art des spannungsausgeglichenen Verbindens kann auch in einem Prozessschritt erfolgen. Hierzu wird auf die zweite Schicht 30, die in die zweite Kupferschicht 25 eingebettet ist, die erste Kupferschicht 20, insbesondere die Kupferleiterbahn, positioniert und darauf wiederum der Halbleiterbaustein 90. Zwischen der ersten Kupferschicht 20 und der zweiten Schicht 30 aus zweitem Material M2 befindet sich die Verbindungsschicht 40 und zwischen dem Halbleiterbaustein 90 und der ersten Kupferschicht 20 die Kontaktierungsschicht 50. Vorzugsweise handelt es sich sowohl bei der Kontaktierungsschicht 50 als auch bei der ersten Verbindungsschicht 40 um eine Silber-Sinterschicht, so dass alle Schichten sowie der Halbleiterbaustein 90 in einem einzigen Prozessschritt miteinander verbunden werden können.

In Fig. 5 wird eine im Vergleich zur Fig. 4 ähnliche Ausführungsform eines Halbleitermoduls 100 dargestellt. Auch in diesem Fall ist die zweite Schicht 30 in die zweite Kupferschicht 25 eingebettet. Zwischen dem Halbleiterbaustein 90 und der zweiten Schicht 30 ist die erste Kupferschicht 20 ausgebildet. Des Weiteren ist eine dritte Kupferschicht 26 ausgebildet. Die zweite Kupferschicht 25 sowie die zweite Schicht 30 sind mit der dritten Kupferschicht 26 mittels einer zweiten Verbindungsschicht 41 aus Verbindungsmaterial VM verbunden.

Insgesamt ist die Fläche der zweiten Schicht 30 aus dehnungsarmem Material, wie z.B. Molybdän, wesentlich kleiner als die Flächen der zweiten Kupferschicht 25 sowie der dritten Kupferschicht 26. Die Verringerung der Fläche der zweiten Schicht 30 ist jedoch nicht geringer als 80 % der Fläche des Halbleiterbausteins 90. Im dargestellten Beispiel gemäß Fig. 5 ist die Fläche der zweiten Schicht 30, wie dies durch die Breite b2 der zweiten Schicht angedeutet ist, größer als die Fläche des Halbleiterbausteins 90. Die Fläche der zweiten Schicht 30 besitzt vorzugsweise das gleiche Seitenverhältnis wie der Halbleiterbaustein 90. Die Reduzierung der Fläche der zweiten Schicht 30 aus dehnungsarmem Material gegenüber den Flächen der zweiten Kupferschicht 25 und der dritten Kupferschicht 26 reduziert die Dehnungsfehlanpassung konzentriert und lokal im Bereich des geringdehnenden Halbleiterbausteins 90.

Die erste Kupferschicht 20 deckt die zweite Schicht 30 vollständig ab. Bei einer pressenden Verbindungstechnik kann aufgrund eines aufgebrachten Montagedrucks eine konturfolgende erste Kupferschicht 20 gebildet werden. Es kann dabei ein Plateau gebildet werden, das den Halbleiterbaustein 90 trägt.

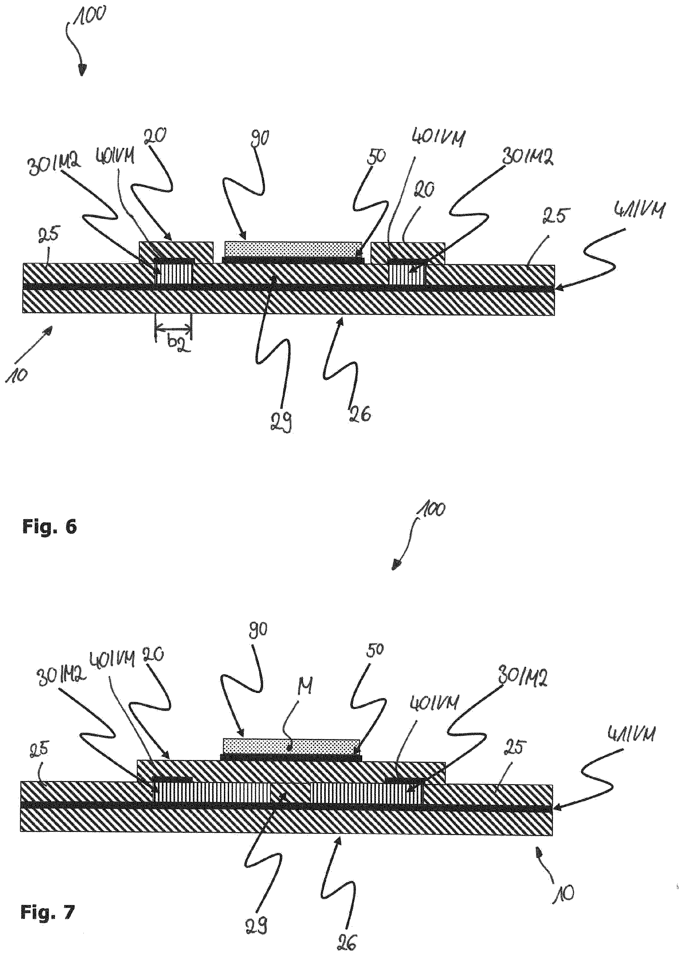

In Fig. 6 wird ein weiteres Halbleitermodul 100 mit einer weiteren Ausführungsform hinsichtlich eines erfindungsgemäßen Schaltungsträgers 10 dargestellt. Die zweite Schicht 30 des Schaltungsträgers 10 ist in diesem Ausführungsbeispiel als rechteckiger Rahmen ausgebildet. Die als rechteckiger Rahmen ausgebildete zweite Schicht 30 aus dehnungsarmem Material ist in die zweite Kupferschicht 25 eingebettet. Die zweite Schicht 30 ist über eine erste Verbindungsschicht 40 aus Verbindungsmaterial VM mit der ersten Kupferschicht 20 verbunden. Auch die erste Kupferschicht 20 ist als rechteckiger Rahmen ausgebildet. Die zweite Schicht 30 umrahmt einen Kupferschichtabschnitt 29, wobei der Halbleiterbaustein 90 oberhalb des Kupferschichtabschnitts 29 ausgebildet ist. Maximal sollten die Kantenlängen des Kupferschichtabschnitts 29 150 % der Kantenlängen des Halbleiterbausteins 90 betragen. Die Breite b2 der rahmenartig ausgebildeten zweiten Schicht 30 beträgt mindestens 10 % und maximal 100 % der kleinsten Kantenlänge des Halbleiterbausteins 90.

Der Schaltungsträger 10 weist des Weiteren eine dritte Kupferschicht 26 auf. Diese dritte Kupferschicht 26 ist mittels einer zweiten Verbindungsschicht 41 mit der zweiten Schicht 30 sowie der zweiten Kupferschicht 25 verbunden.

Die rahmenartige Ausbildung der zweiten Schicht 30 bewirkt eine Dehnungsreduzierung, wobei der Kupferschichtabschnitt 29, auf dem der Halbleiterbaustein 90 mittels einer Kontaktierungsschicht 50 aufgebracht ist, eine maximale z-Wärmeleitfähigkeit aufgrund des Kupfermaterials bewirkt. Als z-Wärmeleitfähigkeit wird die Wärmeleitfähigkeit ausgehend vom Halbleiterbaustein 90 in Richtung der dritten Kupferschicht 26 definiert. Aufgrund einer pressenden Verbindungstechnik, wie z.B. aufgrund eines Sinterverfahrens, kann aufgrund des Montagedruckes eine konturfolgende Kupferschicht gebildet werden. Die mit der ersten Kupferschicht 20 bedeckte zweite Schicht 30 formt dabei ein ebenes, in Richtung des Kupferschichtabschnitts 29 abgesenktes Plateau, das den Halbleiterbaustein 90 trägt.

Der Schaltungsträger 10 des Halbleitermoduls 100 der Fig. 7 weist ebenfalls eine erste Kupferschicht 20, eine zweite Kupferschicht 25 sowie eine dritte Kupferschicht 26 auf. Die zweite Schicht 30 ist in die zweite Kupferschicht 25 eingebettet. Die erste Kupferschicht 20 ist quadratisch oder rechteckig ausgebildet und deckt die zweite Schicht 30 ab. Die erste Kupferschicht 20 ist mittels einer rahmenartig ausgebildeten ersten Verbindungsschicht 40 aus Verbindungsmaterial VM mit der zweiten Schicht 30 verbunden. Die zweite Kupferschicht 25 ist wiederum mit einer zweiten Verbindungsschicht 41 mit der dritten Kupferschicht 26 verbunden.

Die Erstreckung bzw. die Größe der Fläche der zweiten Schicht 30 aus dehnungsarmem Material M2 ist in diesem Ausführungsbeispiel auf eine der Verteilung der mechanischen Scherspannung zwischen dem Halbleiterbaustein 90 und dem Schaltungsträger 10 angepasste Gestalt beschränkt. Die Scherspannung ist zwischen dem Halbleiterbaustein 90 und dem Schaltungsträger 10 entlang der Diagonalen (und darüber hinaus) des Halbleiterbausteins 90 besonders groß. Die Scherspannungsverteilung ist im Wesentlichen punktsymmetrisch zum Mittelpunkt M des Halbleiterbausteins 90.

Eine in diesem Fall minimalst mögliche Ausbildung hinsichtlich der Fläche der zweiten Schicht 30 ergibt also eine Fläche, die sich etwas über die Diagonalen des Halbleiterbausteins 90 hinaus erstreckt. Die Fläche der zweiten Schicht 30 erstreckt sich über die Diagonalen weiter hinaus als im Bereich der Koordinatenachsen des Halbleiterbausteins 90. Die entstehende Flächenform (wäre bei einer Draufsicht auf die zweite Schicht 30 ersichtlich) ähnelt einem vierblättrigen Kleeblatt. Zur Verbesserung der Wärmeleitfähigkeit kann in der zweiten Schicht 30 im Bereich des Mittelpunkts M des Halbleiterbausteins 90 ein Kupferschichtabschnitt 29 ausgebildet sein.

### Bezugszeichenliste

- 10: Schaltungsträger
- 15: erste Seite der ersten Kupferschicht
- 20: erste Kupferschicht
- 25: zweite Kupferschicht
- 26: dritte Kupferschicht
- 29: Kupferschichtabschnitt
- 30: zweite Schicht
- 40: erste Verbindungsschicht
- 41: zweite Verbindungsschicht
- 50: Kontaktierungsschicht
- 90: Halbleiterbaustein
- 100: Halbleitermodul
- b1: Breite erste Kupferschicht
- b2: Breite zweite Schicht
- b3: Breite zweite Kupferschicht
- bHL: Breite Halbleiterbaustein
- d1: Schichtdicke erste Kupferschicht
- d2: Schichtdicke zweite Schicht
- d3: Schichtdicke zweite Kupferschicht
- D: Gesamtdicke
- S: Symmetrieachse
- M: Mittelpunkt Halbleiterbaustein
- M2: zweites Material
- VM: Verbindungsmaterial

## Patentansprüche

1. Verfahren zur Herstellung eines Schaltungsträgers (10),
insbesondere eines Stanzgitters oder einer Leiterbahn, für einen Halbleiterbaustein (90), wobei
mindestens eine erste Kupferschicht (20) oder eine erste Kupferlegierungsschicht mit einem ersten Ausdehnungskoeffizient und mindestens eine zweite Schicht (30) aus einem zweiten, dehnungsarmen Material (M2) mit einem zweiten Ausdehnungskoeffizient, der kleiner als der erste Ausdehnungskoeffizient ist, miteinander verbunden werden,
**dadurch gekennzeichnet, dass**
zwischen der ersten Kupferschicht (20) oder der ersten Kupferlegierungsschicht und der zweiten Schicht (30) mindestens eine erste Verbindungsschicht (40) aus einem Verbindungsmaterial (VM) ausgebildet ist und das Verbindungsmaterial (VM) eine Verbindung herstellt, die Temperaturen überhalb der Verbindungstemperatur standhält und Silber (Ag) und/oder eine Silberlegierung aufweist, wobei das Verbindungsmaterial als Sintermaterial ausgebildet ist,
wobei die erste Kupferschicht (20) oder die erste Kupferlegierungsschicht und die zweite Schicht (30) bei einer Verbindungstemperatur von 150 °C - 300 °C durch ein Niedertemperatursinterverfahren miteinander verbunden werden.

2. Verfahren nach Anspruch 1,
**dadurch gekennzeichnet, dass**
die Verbindungstemperatur 200 °C - 280 °C, insbesondere 220 °C - 270 °C, insbesondere 240 °C - 260 °C, insbesondere 250 °C, beträgt.

3. Verfahren nach einem der vorhergehenden Ansprüche,
**dadurch gekennzeichnet, dass**
das zweite Material (M2) eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), besonders bevorzugt Molybdän (Mo), aufweist.

4. Verfahren nach einem der vorhergehenden Ansprüche,
**dadurch gekennzeichnet, dass**
das Verbinden einer/der Kupferschicht (20) oder einer/der Kupferlegierungsschicht mit der zweiten Schicht (30) und optional der Verbindungsschicht (40, 41) mittels Druckbeaufschlagung, insbesondere mit einem Druck von 5 MPa - 30 MPa, insbesondere von 10 MPa - 28 MPa, insbesondere von 25 MPa, erfolgt.

5. Schaltungsträger (10), insbesondere Stanzgitter oder Leiterbahn, für einen Halbleiterbaustein (90), hergestellt nach einem Verfahren nach einem der Ansprüche 1 bis 4, umfassend:
- mindestens eine erste Kupferschicht (20) oder eine erste Kupferlegierungsschicht mit einem ersten Ausdehnungskoeffizient, und
- mindestens eine zweite Schicht (30) aus einem zweiten, dehnungsarmen Material (M2) mit einem zweiten Ausdehnungskoeffizient, der kleiner als der erste Ausdehnungskoeffizient ist, wobei das zweite Material (M2) eine Nickellegierung, insbesondere Invar (Fe₆₅Ni₃₅) oder Invar 36 (Fe₆₄Ni₃₆) oder Kovar (Fe₅₄Ni₂₉Co₁₇), und/oder Wolfram (W) und/oder eine Eisen-Nickel-Kobalt-Legierung (FeNiCo-Legierung), besonders bevorzugt Molybdän (Mo), aufweist, wobei
zwischen der ersten Kupferschicht (20) oder der ersten Kupferlegierungsschicht und der zweiten Schicht (30) mindestens eine erste Verbindungsschicht (40), die Silber (Ag) und/oder eine Silberlegierung umfasst, ausgebildet ist.

6. Schaltungsträger (10) nach Anspruch 5,
**dadurch gekennzeichnet, dass**
die mindestens erste Verbindungsschicht (40) als Grenzschicht der ersten Kupferschicht (20) oder der ersten Kupferlegierungsschicht und/oder der mindestens zweiten Schicht (30) ausgebildet ist.

7. Schaltungsträger (10) nach einem der Ansprüche 5 bis 6,
**gekennzeichnet durch**
mindestens eine zweite Kupferschicht (25) oder eine zweite Kupferlegierungsschicht, die, vorzugsweise mittels einer zweiten Verbindungsschicht (42) aus einem/dem Verbindungsmaterial (VM), mit der zweiten Schicht (30) aus dem zweiten, dehnungsarmen Material (M2) verbunden ist.

8. Schaltungsträger (20) nach einem der Ansprüche 5 bis 7,
**dadurch gekennzeichnet, dass**
die zweite Schicht (30) in einer Kupferschicht (20, 25, 26) oder einer Kupferlegierungsschicht eingebettet ist.

9. Schaltungsträger (10) nach einem der Ansprüche 5 bis 8,
**dadurch gekennzeichnet, dass**
die zweite Schicht (30) rahmenartig und/oder gitterartig und/oder drahtartig ausgebildet ist.

10. Verfahren zur Herstellung eines Halbleitermoduls (100),
umfassend einen Schaltungsträger (10), insbesondere nach einem der Ansprüche 5 bis 9 oder einen Schaltungsträger (10), der mittels eines Verfahrens nach einem der Ansprüche 1 bis 4 hergestellt ist, und mindestens einen Halbleiterbaustein (90), der mit dem Schaltungsträger (10) verbunden ist,
**dadurch gekennzeichnet, dass**
der Halbleiterbaustein (90) mittels einer Kontaktierungsschicht (50) mit dem Schaltungsträger (10) bei einer Montagetemperatur von 150 °C - 300 °C verbunden wird, wobei die Montagetemperatur im Wesentlichen der Verbindungstemperatur bei der Verbindung von/der Schichten (20, 25, 26, 30, 40, 41) des Schaltungsträgers (10) entspricht.

11. Verfahren nach Anspruch 10,
**dadurch gekennzeichnet, dass**
die Verbindung der Schichten (20, 25, 26, 30, 40, 41) des Schaltungsträgers (10) und die Verbindung des Schaltungsträgers (10) mit dem Halbleiterbaustein (90) gleichzeitig erfolgt.

12. Verfahren nach Anspruch 10 oder 11,
**dadurch gekennzeichnet, dass**
die Montagetemperatur 200 °C - 280 °C, insbesondere 220 °C - 270 °C, insbesondere 240 °C - 260 °C, insbesondere 250 °C, beträgt.

13. Halbleitermodul (100), insbesondere hergestellt nach einem der Ansprüche 10 bis 12, umfassend
einen Schaltungsträger (10) nach einem der Ansprüche 5 bis 9 oder einen Schaltungsträger (10), der mittels eines Verfahrens nach einem der Ansprüche 1 bis 4 hergestellt ist, und
mindestens einen Halbleiterbaustein (90), insbesondere eine Diode oder einen IGBT oder einen MOSFET-Transistor, der mit dem Schaltungsträger (10) verbunden ist.

14. Halbleitermodul (100) nach Anspruch 13,
**dadurch gekennzeichnet, dass**
die zweite Schicht (30) in einer Kupferschicht (20, 25, 26) oder einer Kupferlegierungsschicht eingebettet ist, wobei vorzugsweise der Halbleiterbaustein (90) oberhalb der zweiten Schicht (30) ausgebildet ist.

15. Halbleitermodul (100) nach Anspruch 13,
**dadurch gekennzeichnet, dass**
die zweite Schicht (30) in einer Kupferschicht (20, 25, 26) oder einer Kupferlegierungsschicht eingebettet ist, wobei die zweite Schicht (30) rahmenartig ausgebildet ist und einen Kupferschichtabschnitt (29) oder einen Kupferlegierungsschichtabschnitt umrahmt, wobei vorzugsweise der Halbleiterbaustein (90) oberhalb des Kupferschichtabschnitts (29) oder des Kupferlegierungsschichtabschnitts ausgebildet ist.

16. Halbleitermodul (100) nach Anspruch 15,
**dadurch gekennzeichnet, dass**
die Kantenlängen des Kupferschichtabschnitts (29) oder des Kupferlegierungsschichtabschnitts maximal 150 % der Kantenlängen des Halbleiterbausteins (90) betragen und vorzugsweise die Breite (b2) der rahmenartig ausgebildeten zweiten Schicht (30) 10 % - 100 % der kürzesten Kantenlänge des Halbleiterbausteins (90) beträgt.

## Claims

1. Method for manufacturing a circuit carrier (10), in particular, a lead frame or a printed circuit board track, for a semiconductor component (90), wherein
at least one first copper layer (20) or a first copper alloy layer with a first expansion coefficient and at least a second layer (30) made of a second, low-stretch material (M2) with a second expansion coefficient, which is smaller than the first expansion coefficient, are bonded to each other,
**characterized in that**,
between the first copper layer (20) or the first copper alloy layer and the second layer (30), at least one first bonding layer (40) is made of a bonding material (VM) and the bonding material (VM) creates a bond, which withstands temperatures above the bonding temperature and comprises silver (Ag) and/or a silver alloy, wherein the bonding material is configured as a sintering material,
wherein the first copper layer (20) or the first copper alloy layer and the second layer (30) are bonded to each other at a bonding temperature of 150 °C - 300 °C by means of a low-temperature sintering method.

2. Method according to Claim 1,
**characterized in that**
the bonding temperature is 200 °C - 280 °C, in particular, 220 °C - 270 °C, more preferably 240 °C - 260 °C, and even more preferably 250 °C.

3. Method according to any one of the preceding claims,
**characterized in that**
the second material (M2) comprises a nickel alloy, in particular Invar (Fe₆₅Ni₃₅) or Invar 36 (Fe₆₄Ni₃₆) or Kovar (Fe₅₄Ni₂₉C0₁₇), and/or tungsten (W) and/or an iron-nickel-cobalt alloy (FeNiCo alloy), being particularly preferred, molybdenum (Mo).

4. Method according to any one of the preceding claims,
**characterized in that**
the bonding of a/the copper layer (20) or a/the copper alloy layer to the second layer (30) and optionally, the bonding layer (40, 41) takes place by means of pressurization, in particular, at a pressure of 5 MPa - 30 MPa, more preferably, 10 MPa - 28 MPa, and even more preferably, 25 MPa.

5. Circuit carrier (10), in particular, a lead frame or a printed circuit board track, for a semiconductor component (90), manufactured according to a method according to one of the Claims 1 to 4, comprising:
- at least one first copper layer (20) or a first copper alloy layer with a first expansion coefficient, and
- at least a second layer (30) made of a second, low-stretch material (M2) with a second expansion coefficient, which is smaller than the first expansion coefficient, wherein the second material (M2) comprises a nickel alloy, in particular Invar (Fe₆₅Ni₃₅) or Invar 36 (Fe₆₄Ni₃₆) or Kovar (Fe₅₄Ni₂₉C0₁₇), and/or tungsten (W) and/or an iron-nickel-cobalt alloy (FeNiCo alloy), being particularly preferred, molybdenum (Mo), wherein at least one first bonding layer (40), which comprises silver (Ag) and/or a silver alloy is formed between the first copper layer (20) or the first copper alloy layer and the second layer (30) .

6. Circuit carrier (10) according to Claim 5,
**characterized in that**
the at least first bonding layer (40) is designed as a boundary layer of the first copper layer (20) or of the first copper alloy layer and/or of the at least second layer (30).

7. Circuit carrier (10) according to one of the Claims 5 to 6,
**characterized by**
at least one second copper layer (25) or a second copper alloy layer, which, preferably by means of a second bonding layer (42) made of a/the bonding material (VM), is bonded to the second layer (30) made of a the second low-stretch material (M2).

8. Circuit carrier (20) according to one of the Claims 5 to 7,
**characterized in that**
the second layer (30) is embedded within a copper layer (20, 25, 26) or a copper alloy layer.

9. Circuit carrier (10) according to one of the Claims 5 to 8,
**characterized in that**
the second layer (30) is frame-like and/or grate-like and/or wire-like.

10. Method for manufacturing a semiconductor module (100), comprising a circuit carrier (10), in particular, according to one of the Claims 5 to 9 or a circuit carrier (10), which is manufactured by means of a method according to one of the Claims 1 to 4, and at least one semiconductor component (90), which is bonded to the circuit carrier (10),
**characterized in that**
the semiconductor component (90) is bonded to the circuit carrier (10) by means of a contacting layer (50) at an installation temperature of 150 °C - 300 °C, wherein the installation temperature essentially corresponds to the bonding temperature during the bonding of (the) layers (20, 25, 26, 30, 40, 41) of the circuit carrier (10).

11. Method according to Claim 10,
**characterized in that**
the bonding of the layers (20, 25, 26, 30, 40, 41) of the circuit carrier (10) and the bonding of the circuit carrier (10) to the semiconductor component (90) take place simultaneously.

12. Method according to Claim 10 or 11,
**characterized in that**
the installation temperature is 200 °C - 280 °C, in particular, 220 °C - 270 °C, more preferably 240 °C - 260 °C, and even more preferably, 250 °C.

13. Semiconductor module (100), in particular, manufactured according to one of the Claims 10 to 12, comprising
a circuit carrier (10) according to one of the Claims 5 to 9, or a circuit carrier (10), which is manufactured by means of a method according to one of the Claims 1 to 4,
and at least one semiconductor component (90), in particular, a diode or an insulated-gate bipolar transistor or a metal-oxide-semiconductor field-effect transistor, which is bonded to the circuit carrier (10).

14. Semiconductor module (100) according to Claim 13,
**characterized in that**
the second layer (30) is embedded within a copper layer (20, 25, 26) or a copper alloy layer, wherein, preferably, the semiconductor component (90) is formed above the second layer (30).

15. Semiconductor module (100) according to Claim 13,
**characterized in that**
the second layer (30) is embedded within a copper layer (20, 25, 26) or a copper alloy layer, wherein the second layer (30) is frame-like and frames a copper layer section (29) or a copper alloy layer section, wherein, preferably, the semiconductor component (90) is formed above the copper layer section (29) or the copper alloy layer section.

16. Semiconductor module (100) according to Claim 15,
**characterized in that**
the edge lengths of the copper layer section (29) or the copper alloy layer section are a maximum of 150 % of the edge lengths of the semiconductor component (90) and, preferably, the width (b2) of the frame-like second layer (30) is 10 % - 100 % of the shortest edge length of the semiconductor component (90).

## Revendications

1. Procédé de fabrication d'un porte circuit (10), notamment d'une grille de connexion découpée ou d'une piste conductrice, pour un composant à semi-conducteurs (90), dans lequel
au moins une première couche de cuivre (20) ou une première couche d'alliage de cuivre avec un premier coefficient de dilatation et au moins une deuxième couche (30) constituée d'un deuxième matériau peu extensible (M2) avec un deuxième coefficient de dilatation, qui est plus petit que le premier coefficient de dilatation sont reliés l'une à l'autre,
**caractérisé en ce que**
entre la première couche de cuivre (20) ou la première couche d'alliage de cuivre et la deuxième couche (30) au moins une première couche de liaison (40) constituée d'un matériau de liaison (VM) est réalisée et le matériau de liaison (VM) établit une liaison, qui maintient les températures au - dessus de la température de liaison et présente de l'argent (Ag) et/ou un alliage d'argent, dans lequel le matériau de liaison est réalisé par un matériau de frittage,
dans lequel la première couche de cuivre (20) ou la première couche d'alliage de cuivre et la deuxième couche (30) sont reliées l'une à l'autre à une température de liaison de 150 °C - 300 °C au moyen d'un procédé de frittage à basse température.

2. Procédé selon la revendication 1,
**caractérisé en ce que**
la température de liaison s'élève à 200 °C - 280 °C, notamment 220 °C - 270 °C, notamment 240 °C - 260°C, notamment 250 °C.

3. Procédé selon une des revendications précédentes,
**caractérisé en ce que**
le deuxième matériau (M2) présente un alliage de nickel, notamment de l'invar (Fe₆₅Ni₃₅), ou invar 36 (Fe₆₄Ni₃₆) ou du covar (Fe₅₄Ni₂₉Co₁₇) et/ou du tungstène (W) et/ou un alliage de fer - nickel - cobalt (alliage FeNiCo), notamment de préférence du molybdène (Mo).

4. Procédé selon une des revendications précédentes,
**caractérisé en ce que**
la liaison d'une /de la couche de cuivre (20) ou d'une/de la couche d'alliage de cuivre avec la deuxième couche (30) et optionnellement de la couche de liaison (40, 41) a lieu au moyen d'une sollicitation par pression, notamment avec une pression de 5 MPa - 30 MPa, notamment de 10 MPa - 28 MPa, notamment de 25 Mpa.

5. Porte circuit (10), notamment grille de connexion découpée ou piste conductrice, pour un composant à semi-conducteurs (90), fabriqué conformément à un procédé selon une des revendications 1 à 4, comprenant :
- au moins une première couche de cuivre (20) ou une première couche d'alliage de cuivre avec un premier coefficient de dilatation, et
- au moins une deuxième couche (30) constituée d'un deuxième matériau peu extensible (M2) avec un deuxième coefficient de dilatation dans lequel le deuxième matériau (M2) présente un alliage de nickel, notamment de l'invar (Fe₆₅,Ni₃₅), ou invar 36 (Fe₆₄Ni₃₆) ou du covar (Fe₅₄Ni₂₉Co₁₇) et/ou du tungstène (W) et/ou un alliage de fer - nickel - cobalt (alliage FeNiCo), notamment de préférence du molybdène (Mo), dans lequel entre la première couche de cuivre (20) ou la première couche d'alliage de cuivre la deuxième couche (30) au moins une première couche de liaison (40), qui contient de l'argent (Ag) et/ou un alliage d'argent, est réalisée.

6. Porte circuit (10) selon la revendication 5,
**caractérisé en ce que**
au moins une première couche de liaison (40) est réalisée comme une couche d'interface de la première couche de cuivre (20) ou la première couche d'alliage de cuivre et/ou au moins une deuxième couche (30) est réalisée.

7. Porte circuit (10) selon une des revendications 5 à 6,
**caractérisé par**
au moins une deuxième couche de cuivre (25) ou une deuxième couche d'alliage de cuivre, qui est reliée, de préférence au moyen d'une deuxième couche de liaison (42) constituée d'un/du matériau de liaison (VM), avec la deuxième couche (30) constituée du deuxième matériau peu extensible (M2).

8. Porte circuit (10) selon une des revendications 5 à 7,
**caractérisé en ce que**
la deuxième couche (30) est incorporée dans une couche de cuivre (20, 25, 26) ou dans une couche d'alliage de cuivre.

9. Porte circuit (10) selon une des revendications 5 à 8,
**caractérisé en ce que**
la deuxième couche (30) est configuré en forme de cadre et/ou de grillage et/ou de fil.

10. Procédé de fabrication d'une module à semi-conducteurs (100) comprenant un porte circuit (10), notamment selon une des revendications 5 à 9 ou un porte circuit (10), qui est fabriqué au moyen d'un procédé selon une des revendications 1 à 4, et au moins un composant à semi-conducteurs (90), qui est reliée avec le porte circuit (10),
**caractérisé en ce que**
le composant à semi-conducteurs (90) est relié au moyen d'une couche de contact (50) avec le porte circuit (10) en présence des températures de montage de 150 °C - 300 °C, dans lequel la température de montage correspond essentiellement à la température de liaison lors de la liaison de la/des couches (20, 25, 26, 30, 40, 41) du porte circuit (10).

11. Procédé selon la revendication 10,
**caractérisé en ce que**
la liaison des couches (20, 25, 26, 30, 40, 41) du porte circuit (10) et la liaison du porte circuit (10) avec le composant à semi-conducteurs (90) a lieu simultanément.

12. Procédé selon la revendication 10 ou 11,
**caractérisé en ce que**
la température de montage s'élève à 200 °C - 280 °C, notamment 220 °C - 270 °C, notamment 240 °C - 260°C, notamment 250 °C.

13. Module à semi-conducteurs (100), notamment fabriqué selon une des revendications 10 à 12,
comprenant un porte circuit (10) selon une des revendications 5 à 9 ou un porte circuit (10), qui est fabriqué au moyen d'un procédé selon une des revendications 1 à 4, et
au moins un composant à semi-conducteurs (90), notamment une diode ou à un transistor IGBT ou MOSFET, qui est relié avec le porte circuit (10).

14. Module à semi-conducteurs (100) selon la revendication 13,
**caractérisé en ce que**
la deuxième couche (30) est incorporé dans une couche de cuivre (20, 25, 26) ou une couche d'alliage de cuivre, dans lequel de préférence le composant à semi-conducteurs (90) est réalisé au - dessus de la deuxième couche (30).

15. Module à semi-conducteurs (100) selon la revendication 13,
**caractérisé en ce que**
la deuxième couche (30) est incorporé dans une couche de cuivre (20, 25, 26) ou une couche d'alliage de cuivre, dans lequel la deuxième couche (30) est réalisé en forme de cadre et encadre une portion de couche de cuivre (29) ou une portion de couche d'alliage de cuivre, dans lequel de préférence le composant à semi-conducteurs (90) est réalisé au - dessus de la portion de couche de cuivre (29) ou de la portion de couche d'alliage de cuivre.

16. Module à semi-conducteurs (100) selon la revendication 15,
**caractérisé en ce que**
les longueurs d'arêtes de la portion de couche de cuivre (29) ou de la portion de couche d'alliage de cuivre s'élève au maximum à 150 % des longueurs d'arêtes du composant à semi-conducteurs (90) et de préférence la largeur (b2) de la deuxième couche réalisée en forme de cadre (30) s'élève à 10 % - 100 % de la longueur d'arête la plus courte du composants à semi-conducteurs.
